# EUROPEAN PATENT APPLICATION

(11) **EP 4 742 538 A1**
(43) Date of publication of application: **13.05.2026**
(21) Application number: 24220806.4
(22) Date of filing: 17.12.2024
(51) Int. Cl.: H03K 17/082

(54) **POWER CONTROL APPARATUS**

(30) Priority: 11.11.2024 EP 24212207
(71) Applicant: Future Systems Besitz GmbH, 96472 Rödental (DE)
(72) Inventor: Först, Bernhard, 96317 Kronach (DE)
(74) Representative: Bratovic, Nino Maria

(57) **Abstract**

In summary, the present invention relates to a power control apparatus for controlling electrical current between an input terminal and an output terminal. The current in the path between these two terminals can be monitored, with the monitoring signal corresponding to the current in the path being adjustable based on the temperature within the control apparatus.

## Description

The invention relates to a power control apparatus. In particular, the present invention relates to an apparatus that controls power supply by evaluating the current supplied by the power control apparatus.

Electrical loads connected to a power supply system often require control of the supplied electrical power, particularly to protect the connected electrical loads. Such loads may need protection from overload and overcurrent. Additionally, electrical loads connected to a power supply system must sometimes be turned on or off. Therefore, the electrical power supplied to these loads needs to be conditioned during both the turn-on and turn-off phases. A connected load may also have different operational modes, each requiring adaptation or conditioning of the supplied electrical power.

Conventional electrical protection devices often use current sensors to measure the current flowing to the connected load, enabling detection of critical situations and automatic triggering of an electronic or electromechanical switch if a critical situation is detected. A current measurement element, such as a Hall sensor, can measure the electrical current and provide corresponding measurement values to an integrated controller, which may switch off relevant components of the protection device if the measured current values exceed a predetermined threshold. Some conventional protection devices use semiconductor switches, such as MOSFETs, to protect connected loads against overcurrents or overloads.

However, these conventional protection devices typically require sensor elements in the current supply path to measure the electrical current flowing to the connected load. These sensor elements can cause additional energy losses and may hinder the miniaturization of the electrical protection device.

In particular, when electrical current is monitored by a lossy electrically conductive component, such as an inductor, it may result in energy losses that must then be dissipated as heat. This heat may cause a temperature-dependent effects, for example in the switching elements of a device controlling the power flow.

Accordingly, the objective of the present invention is to provide a power control apparatus that can control the electrical power supplied while accounting for temperature-dependent effects. In particular, the invention aims to offer a concept for compensating for variations caused by changes in temperature or other influencing factors.

This objective is achieved by the features of the independent claim. Further advantageous embodiments are subject matter of the dependent claims

### Summary

In an aspect of the present invention, a power control apparatus is provided. The power control apparatus may be configured for controlling electrical power supplied to a connected load. The apparatus comprises an input terminal, an output terminal, a semiconductor switching stage through which the connected load receives the load current, an evaluation circuit and a thermal compensation unit. The input terminal may be configured to be connected to an electrical power source. The output terminal may be configured to be connected to the load. The semiconductor stage comprises two power switching modules. Each power switching module may comprise one or more power switching elements such as a semiconductor switch. The individual switching elements of a power switching module may be arranged in parallel. The two power switching modules may be arranged in series between the input terminal and the output terminal. In particular, the two power switching modules have opposite orientations. Accordingly, by this opposite orientation of the two power switching modules, the power switching stage is able to interrupt an electrical current independent of the polarity of the applied voltage. The evaluation circuit is adapted to evaluate a current between the input terminal and the output terminal. In particular, the evaluation circuit may be adapted to evaluate the voltage drop over the semiconductor switching stage. Thus, a switching status of the semiconductor switching stage may be controlled or influenced based on the evaluation performed by the evaluation circuit. Especially, the evaluation circuit may provide an output signal based on the evaluated current. The thermal compensation unit is adapted to adjust the output signal provided by the evaluation circuit. In particular, the thermal compensation unit may adjust the output signal based on a temperature in the power path between the input terminal and the output terminal.

The present invention is based on the finding that at least some properties of electronic components such as semiconductor switches or signals which relate to the sensed properties such as a current, voltage or the like, may vary depending on the temperature. Thus, when designing devices with such temperature-dependent properties, the devices must be dimensioned so that they can handle these variations even under the most unfavourable conditions. This may lead to huge safety margins, making devices large and expensive.

The present invention therefore takes into account these findings and aims to provide a concept for controlling a power control apparatus more reliable even under the conditions of the temperature variations. For this purpose, the present invention introduces a concept of temperature compensation for signals which serve as a basis for controlling the power control apparatus. Due to such a temperature compensation of the control signals, the operation of the control strategy can be performed more precisely in view of the real temperature conditions and the related deviations of the individual components. Thus, safety margins can be reduced.

In a possible embodiment, the power control apparatus may comprise at least one conductive or inductive elements in the current path between the input terminal and the output terminal. In particular, such a conductive or inductive element may be positioned between the input terminal and the semiconductor switching stage and/or between the semiconductor switching stage and the output terminal. Accordingly, a voltage drop over the conductive or inductive elements may be analysed by the evaluation circuit in order to identify conditions of the current flowing through the power control apparatus between the input terminal and the output terminal.

For example, a conductive element may be used in order to analyse an amplitude of the current between the input terminal and the output terminal. Additionally or alternatively, an inductive element may be used in order to analyse a gradient of the current between the input terminal and the output terminal.

In a possible embodiment, the temperature in the power path between the input terminal and the output terminal may comprise a temperature of the semiconductor switching stage. In this way, temperature-dependent properties related to the semiconductor switches in the semiconductor switching stage may be considered for the operational strategy of the power control apparatus.

In a possible embodiment, the thermal compensation unit may comprise a temperature-dependent resistor. For example, such a temperature-dependent resistor may be located nearby or close to the semiconductor switching stage. Alternatively, another temperature-dependent device may be used. Further, it may be also possible to use a combination of one or more conventional resistors together with one or more temperature-dependent devices, specifically temperature-dependent resistors.

In a possible embodiment, the thermal compensation unit may comprise a compensation network with multiple electronic components such as resistors or and/or capacitors. Accordingly, the compensation network may be adapted to selectively connect individually one or more of these electronic devices to an output port providing the output signal. Accordingly, by controlling the connection of the individual electronic components such as resistors or capacitors to this output port, the electronic properties at this output port may be adapted. In particular, the connection of the electronic components to the output port may be controlled based on a temperature, specifically a temperature of the semiconductor switching stage or another relevant position in connection with temperature-dependent properties.

In a possible embodiment, the power control apparatus may comprise a processing unit. The processing unit may be realised, for example, by a processor and a related memory storing instructions which causes the processor to perform desired operations. Furthermore, the processing unit may be realised, for example, by a field programmable gate array (FPGA) or another device which is capable to perform the desired operations. The processing device may be configured to control the compensation network. In particular, the processing unit may control the compensation network based on a temperature, for example a temperature in the power path between the input terminal and the output terminal. In this way, the control unit may selectively connect the individual electronic components of the compensation network to the output port.

In a possible embodiment, the power control apparatus may comprise at least one temperature sensor. The at least one temperature sensor may be configured to provide a sensor signal that corresponds to a temperature, specifically to a temperature in the power path between the input terminal and the output terminal. For example, such temperature sensor may be a temperature-dependent resistor or another temperature-dependent electronic component. In this way, the temperature at the relevant spatial positions in the power control apparatus can be monitored and the temperature compensation can be applied based on the sensed temperature.

Additionally or alternatively, it may be also possible to apply a temperature model in the processing unit. For example, the processing unit may determine a temperature in the current path between the input terminal and the output terminal based on other parameters, such as a sensed current, specifically a sensed current over time. In such an approach, the temperature may be calculated, for example, based on a predetermined formula or based on data stored in a memory, for example a lookup table or the like.

In a possible embodiment, the thermal compensation unit may comprise a configuration unit. Such a configuration unit may be configured to adjust degree of thermal compensation for the output signal. Accordingly, the thermal compensation performed by the thermal compensation unit may be adjusted, specifically adjusted based on further requirements or constraints. In this way, the operational properties of the power control apparatus can be further fit to the desired operational properties.

In a possible embodiment, the configuration unit may comprise a communication interface. Such a communication interface may be configured to establish a communication to a remote device. For example, the communication interface may be used to receive data for adjusting the thermal compensation. Additionally or alternatively, the communication interface may be also used for providing an output signal or outputting appropriate data. For example, the communication interface may output data related to the current temperature, in particular the temperature used for the temperature compensation. Further, the communication interface may output an indication is a predetermined threshold is exceeded.

In a possible embodiment, the configuration unit may comprise an input unit for receiving at least one input parameter. Such input parameter may be received, for example, from a user. Additionally or alternatively, the input parameter may be received from a remote device. In case the input parameter shall be received from a user, the input unit may include, for example, one or more switches, jumpers or the like. Accordingly, the user can easily configure these switches jumpers or the like in order to set a desired configuration. In such a case, the current configuration can be easily recognised at any point in time by the user in order to verify the configuration.

In a possible embodiment, the power control apparatus may comprise a memory for providing a relationship between the temperature, in particular the temperature in the power path between the input terminal and the output terminal, and the degree of thermal compensation for the output signal. In particular, such a memory may be a non-volatile memory. For example, the data stored in this memory may be re-written based on data received by the communication interface. Alternatively, the memory may be a memory which can be written only once. In this case, it can be ensured that the stored data cannot be manipulated at a later point in time.

### Brief description of the Drawings

In the following, possible embodiments of the different aspects of the present invention are described in detail with reference to the enclosed figures.
- Fig. 1:: shows a schematic diagram illustrating the basic principle of a power control apparatus;
- Fig. 2:: shows a schematic diagram of a power control apparatus with coupled coils according to an embodiment;
- Fig. 3:: shows a schematic diagram of a top of a power control apparatus with coupled coils according to an embodiment;
- Fig. 4:: shows a schematic diagram of a cross-sectional view of power control apparatus with two magnetically coupled coils according to an embodiment;
- Fig. 5:: a schematic diagram of a power control apparatus according to a further embodiment;
- Fig. 6:: shows a schematic diagram of a cross-sectional view of power control apparatus according to a further embodiment;
- Fig. 7:: shows a schematic circuit diagram illustrating the basic principle of a temperature compensated power control apparatus according to an embodiment; and
- Fig. 8:: shows a schematic circuit diagram illustrating of a power control apparatus with a temperature compensation network according to an embodiment.

### Embodiments

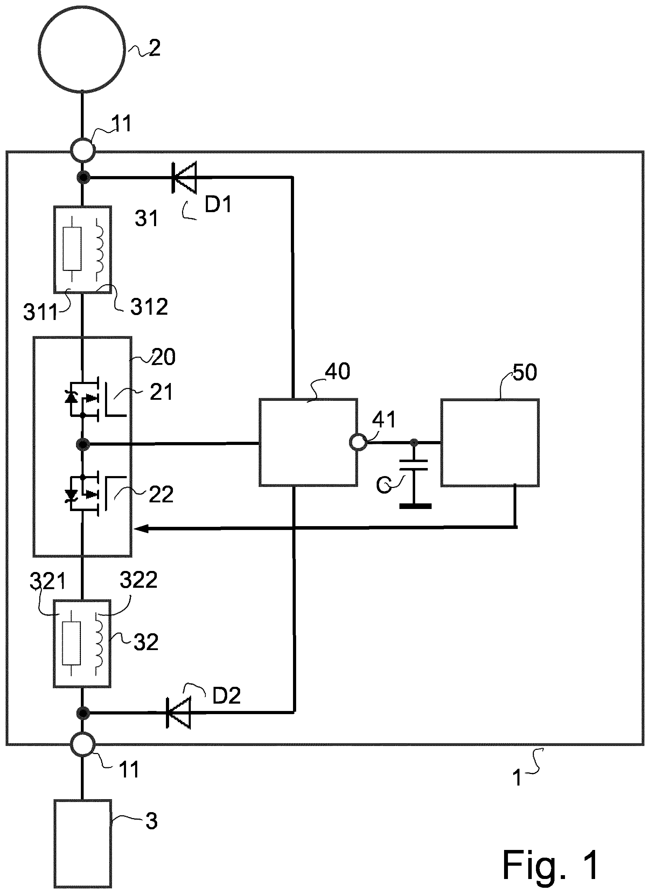

Fig. 1 shows a schematic diagram illustrating the basic principle underlying power control apparatus 1 according to an embodiment. Power control apparatus 1 comprises an input terminal 11 and an output terminal 12. Input terminal 11 may be connected to an electrical power source 2, which could be a DC or AC power source. Output terminal 12 may be connected to an electrical load 3, which operates using power provided by power source 2. For example, electrical load 3 could be an electric machine.

Power control apparatus 1 also includes a semiconductor switching stage 20, arranged in a current path between input terminal 11 and output terminal 12. Semiconductor switching stage 20 comprises two switching modules 21 and 22, each of which includes at least one semiconductor switching element. If switching modules 21 and 22 comprise multiple switching elements, these may be arranged in parallel. The switching elements might be MOSFETs or other suitable semiconductor devices. Importantly, the orientation of the switching elements in module 21 is opposite to that in module 22, allowing semiconductor switching stage 20 to interrupt the voltage between terminals 11 and 12 regardless of polarity.

Additionally, a first electrical component 31 is located between input terminal 11 and semiconductor switching stage 20, while a second electrical component 32 is positioned between semiconductor switching stage 20 and output terminal 12. These components 31 and 32 may include conductive elements 311 and 321, such as components with specific ohmic resistance. Alternatively, they could contain inductive elements 312 and 322, like coils with specific inductance.

To evaluate the magnitude or gradient of the electrical current, it may not be necessary to consider its polarity between input terminal 11 and output terminal 12. Accordingly, evaluation circuit 40 may include a rectifying circuit 42 that rectifies input signals, such as voltage drops across components 31 and 32.

Power control apparatus 1 also comprises an evaluation circuit 40, which assesses the current between input terminal 11 and output terminal 12. For example, evaluation circuit 40 may generate an output signal based on the current between these terminals. This output may appear at an output port 41 of evaluation circuit 40. Evaluation circuit 40 may be electrically connected to input terminal 11 and/or output terminal 12. As shown in Fig. 1, a first diode D1 links input terminal 11 with evaluation circuit 40, while a second diode D2 connects output terminal 12 to evaluation circuit 40. Evaluation circuit 40 is grounded to the same virtual ground as the connection point between switching modules 21 and 22 in semiconductor switching stage 20. Evaluation circuit 40 may also receive control signals for the switching elements within modules 21 and 22.

The output signal from evaluation circuit 40 may be sent to a trigger and control device 50. For example, output port 41 of evaluation circuit 40 could be electrically connected to an input port of trigger and control device 50. As illustrated in Fig. 1, capacitor C1 may be connected between output port 41 of evaluation circuit 40 and the virtual ground. Trigger and control device 50 generates appropriate control signals, which are applied to the control terminals of the semiconductor switches within semiconductor switching stage 20. Specifically, trigger and control device 50 may cause semiconductor switching stage 20 to interrupt the electrical connection between input terminal 11 and output terminal 12 upon detecting a predetermined condition. This condition could be, for instance, a current between input and output terminals 11 and 12 that exceeds a specified threshold, or an increase in the current gradient beyond a defined limit.

To assess the gradient of electric current between input terminal 11 and output terminal 12, components 31 and 32 may include inductive elements 312 and 322, such as coils or similar devices.

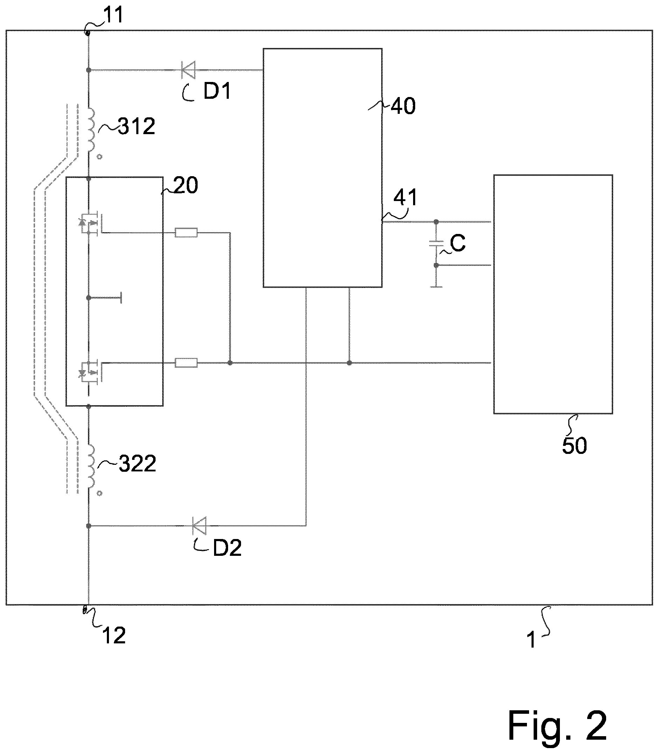

Fig. 2 shows a schematic diagram of power control apparatus 1 according to another embodiment. This apparatus is largely similar to the previously described power control apparatus in Fig. 1 but differs in that both electrical components 31 and 32 now contain coils 312 and 322, respectively, which are magnetically coupled. Specifically, coils 312 and 322 are positioned so that the magnetic field of the first coil 312, located between input terminal 11 and semiconductor switching stage 20, and the second coil 322, situated between semiconductor switching stage 20 and output terminal 12, constructively superimpose.

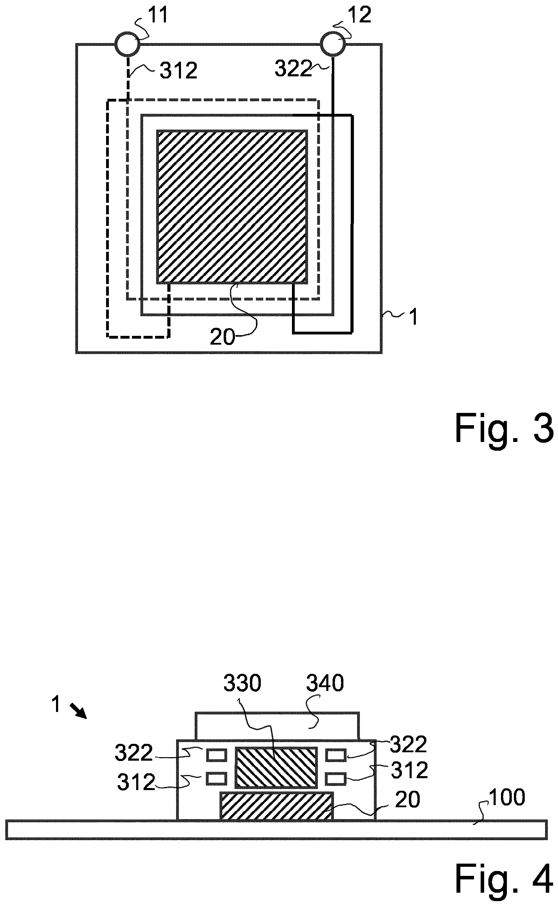

Fig. 3 shows a top view of power control apparatus 1 according to an embodiment. In this embodiment, power control apparatus 1 includes two magnetically coupled coils 312 and 322, as described in relation to Fig. 2. Coils 312 and 322 may be positioned one above the other. Alternatively, coils 312 and 322 could have a bifilar configuration.

Power control apparatus 1 also includes semiconductor switching stage 20, as previously described. Semiconductor switching stage 20 may be arranged, for instance, on a printed circuit board 100. Coils 312 and 322 might be positioned above semiconductor switching stage 20, effectively situating semiconductor switching stage 20 between coils 312 and 322 and the printed circuit board. Alternatively, coils 312 and/or 322 could encircle semiconductor switching stage 20, with the switching stage located within the loop formed by either or both coils.

Fig. 4 shows a cross-sectional view of power control apparatus 1 according to a further embodiment. Power control apparatus 1 in this embodiment also comprises two magnetically coupled coils 312 and 322, as already described above. In this embodiment, a magnetic core 330 may be arranged within coils 312 and 322. This magnetic core 330 may comprise a magnetically conductive material, such as ferrite or a similar material, to enhance the magnetic coupling between coils 312 and 322.

The magnetic core 330 is electrically isolated from the windings of both coil 312 and coil 322, as well as from semiconductor switching stage 20. This isolation may be achieved using appropriate insulating material, such as an insulating lacquer. Alternatively, insulating elements, such as an insulating film or foil, may be positioned between magnetic core 330 and the windings of coils 312 and 322 and/or semiconductor switching stage 20. In principle, magnetic core 330 may be entirely electrically isolated from all other components within the current path between input terminal 11 and output terminal 12.

Magnetic core 330 may also have thermally conductive properties. Specifically, magnetic core 330 may be thermally coupled with semiconductor switching stage 20 and/or coils 312 and 322. This allows magnetic core 330 to dissipate heat generated by semiconductor switching stage 20 and/or coils 312 and 322. Optionally, power control apparatus 1 may include a cooling element 340, which could provide additional cooling. Cooling element 340 may be thermally coupled to magnetic core 330, allowing it to transfer heat from semiconductor switching stage 20 and/or coils 312 and 322 to cooling element 340.

Cooling element 340 could be a passive device, such as a heatsink, potentially with cooling fins for heat dissipation. Alternatively, cooling element 340 could include an active cooler, such as a fan.

As shown in Fig. 4, some components of power control apparatus 1 may be embedded within a moulding material. For instance, coils 312 and 322 along with magnetic core 330 could be enclosed by moulding material. Optionally, the coils 312 and 322 and semiconductor switching stage 20 could also be embedded. The entire assembly, including coils 312 and 322, semiconductor switching stage 20, and additional components like evaluation circuit 40 and trigger and control device 50, may be encased in the moulding material.

The moulding material may have electrical insulating properties and may also be thermally conductive to aid in dissipating heat from individual components to the surrounding environment.

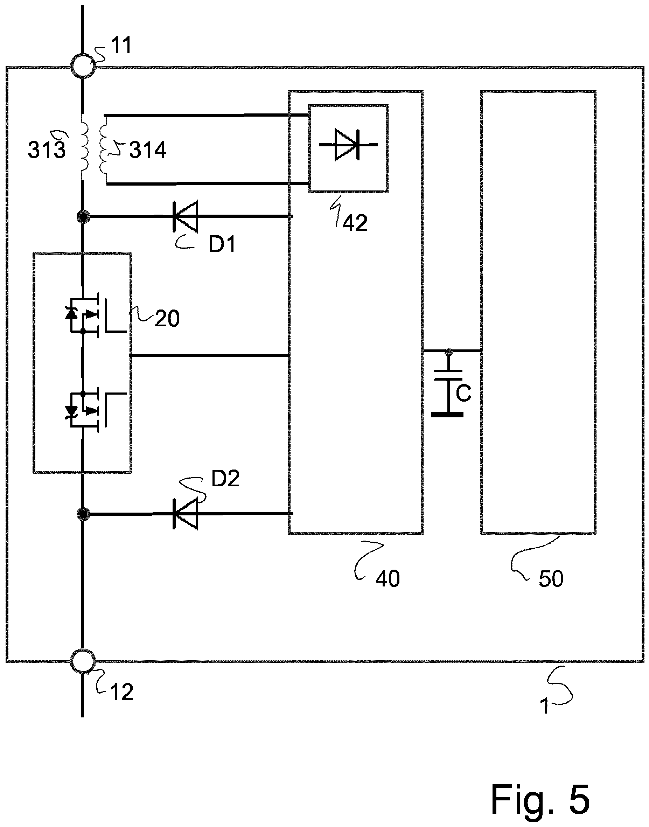

Fig. 5 shows power control apparatus 1 according to a further embodiment. In this version, power control apparatus 1 differs from the previously described apparatus (as shown in Fig. 1) by having a conductive element 313 positioned between input terminal 11 and semiconductor switching stage 20. Conductive element 313 may comprise a linear or nearly linear conductive line, such as a conductive path on a printed circuit board. For example, this conductive path may be a signal line made of copper or another conductive material. Alternatively, conductive element 313 could also be implemented as a conductive wire.

In addition, an induction element 314 may be located adjacent to conductive element 313. Induction element 314 may be formed by one or more loops-specifically, closed loops-of an electrically conductive material. For example, induction element 314 could be made using a conductive path on a printed circuit board, forming one or more loops near conductive element 313.

When current flows through conductive element 313 from input terminal 11 into semiconductor switching stage 20, it generates a surrounding magnetic field. This magnetic field can be detected by induction element 314, where it may induce a current. The resulting current or voltage may then be provided to evaluation circuit 40. Evaluation circuit 40 can analyse the output from induction element 314 to assess the current through conductive element 313, thereby determining the current between input terminal 11 and output terminal 12.

As depicted in Fig. 5, evaluation circuit 40 may include a rectifying circuit 42. Rectifying circuit 42 can rectify the output signal from induction element 314, thus producing a signal corresponding to the current between input terminal 11 and output terminal 12.

Although Fig. 5 shows conductive element 313 and induction element 314 between input terminal 11 and semiconductor switching stage 20, these elements could also be positioned between semiconductor switching stage 20 and output terminal 12. It may also be possible to place a conductive element 313 and an induction element 314 on both sides of semiconductor switching stage 20: one pair between input terminal 11 and the semiconductor switching stage 20, and another pair between the semiconductor switching stage 20 and output terminal 12.

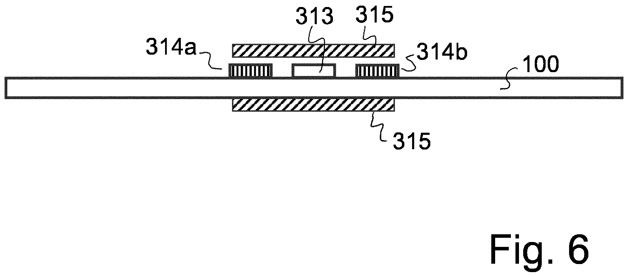

Fig. 6 provides a cross-sectional view of power control apparatus 1 in another embodiment. In this embodiment induction element 314 is divided into two sections, 314a and 314b. These sections are positioned on opposite sides of conductive element 313 and may be located on a printed circuit board 100. Both conductive element 313 and induction elements 314a and 314b could be implemented as conductive paths on printed circuit board 100.

One or more coupling elements 315 may also be added to the assembly with conductive element 313 and induction elements 314a and 314b. These coupling elements 315 may comprise magnetically conductive material, such as ferrite. Importantly, coupling elements 315 are electrically isolated from conductive element 313 and induction elements 314a and 314b, possibly through an insulating coating or foil. A coupling element 315 could be situated above or below the arrangement of conductive element 313 and induction elements 314a and 314b, potentially on the opposite side of printed circuit board 100.

In addition to the configurations of conductive element 313 and induction element 314 described above, other setups, such as planar transformers or flat-type transformers, may be used to transfer current in the path between input terminal 11 and output terminal 12 to a separate galvanically isolated section. This setup could produce an output signal that corresponds to the current between input terminal 11 and output terminal 12.

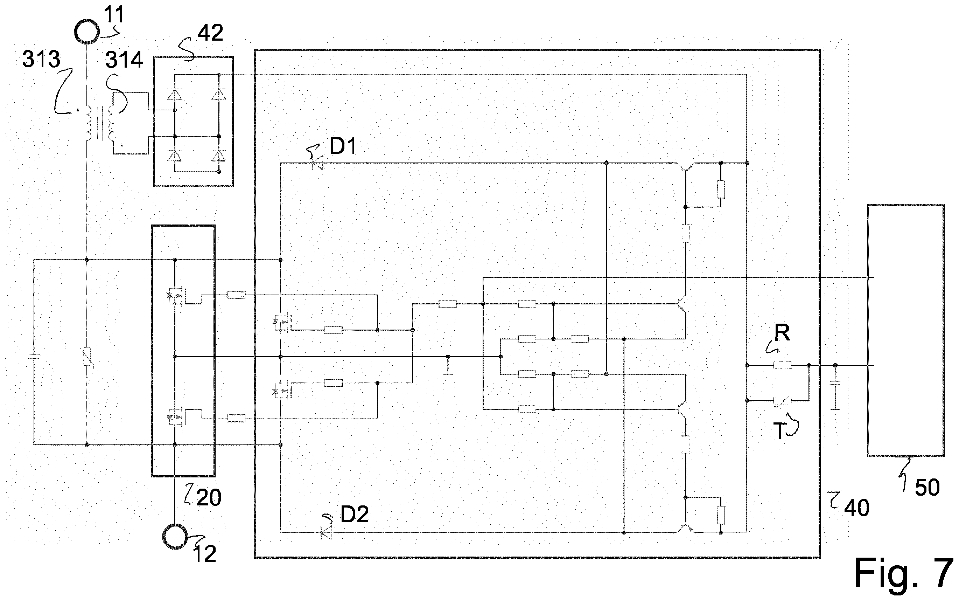

Fig. 7 shows a schematic circuit diagram of power control apparatus 1 according to an embodiment. In this embodiment, power control apparatus 1 utilises the previously described configuration of conductive element 313 and induction element 314. The output signal provided by induction element 314 may be rectified by rectifier circuit 42, and the resulting output is fed to evaluation circuit 40. This signal may then be used to assess the gradient of current flowing between input terminal 11 and output terminal 12.

Additionally, evaluation circuit 40 may be connected via diode D1 to the connection point between conductive element 313 and semiconductor switching stage 20. It may also connect via diode D2 to the point between semiconductor switching stage 20 and output terminal 12. These signals can be utilised to evaluate the amplitude of the current flowing between input terminal 11 and output terminal 12.

The output signal from evaluation circuit 40 may be provided at an output terminal 41, which may also connect to capacitor C1. The opposite terminal of capacitor C1 may be connected to virtual ground. The output signal at output terminal 41 may then be received by trigger and control circuit 50.

Some components of power control apparatus 1 may exhibit temperature-dependent properties. For instance, the resistance of the semiconductor switches within semiconductor switching stage 20, when in a closed (conductive) state, may vary depending on the temperature of each respective semiconductor and, consequently, on the temperature of semiconductor switching stage 20. This dependency might be linear or follow another specific function. Additionally, other elements within power control apparatus 1 may also exhibit temperature-related dependencies.

To account for this temperature dependency, power control apparatus 1 may apply a suitable temperature compensation mechanism. For example, a temperature-dependent resistor T may be used, positioned near or close to semiconductor switching stage 20. As illustrated in Fig. 7, temperature-dependent resistor T may be arranged in parallel with an additional resistor R. Both temperature-dependent resistor T and additional resistor R could be placed in parallel between the two output terminals of rectifier circuits 42.

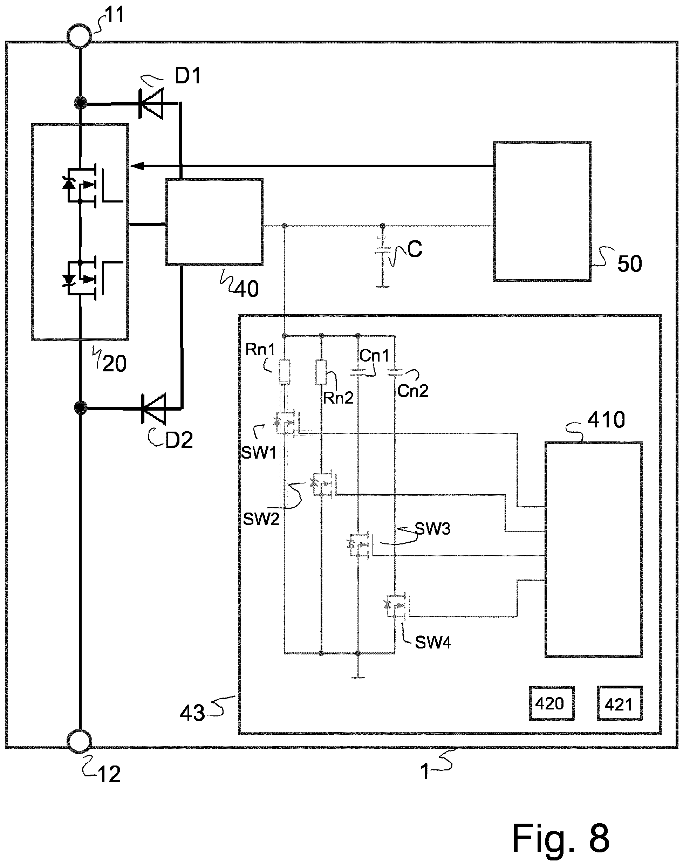

Fig. 8 shows a schematic diagram of power control apparatus 1 according to a further embodiment. In this version, power control apparatus 1 includes a thermal compensation unit 43, located at output port 41 of evaluation circuit 40. In a simple configuration, thermal compensation unit 43 may consist of at least one temperature-dependent resistor T, as described previously.

Alternatively, thermal compensation unit 43 may include a compensation network, as depicted in Fig. 8. This compensation network could contain multiple elements, such as resistors or capacitors. Although the example in Fig. 8 illustrates a network with two resistors Rn1 and Rn2 and two capacitors Cn1 and Cn2, any other number or combination of elements could be possible. Furthermore, each path of the compensation network may contain a combination of multiple electronic components.

Each path in the compensation network may be individually activated or deactivated. For this purpose, each path may include a switch SW1-SW4. The switches SW1-SW4 could be semiconductor switches, such as MOSFETs.

A path can be activated by closing the respective switch SW1-SW4, and deactivated by opening the switch. Any suitable combination of paths may be applied, and it could be possible to activate multiple paths in parallel.

Control unit 410 could manage the operation of each switch SW1-SW4, providing individual control signals for each switch. Control unit 410 may consider the temperature of power control apparatus 1, particularly the temperature of semiconductor switching stage 20 and/or other components. For example, one or more temperature sensors could be positioned appropriately - such as close to semiconductor switching stage 20 - to provide temperature readings. The sensor signal could be sent to control unit 410 via an appropriate interface 420. Alternatively, it may be possible to estimate the temperature of power control apparatus 1, specifically semiconductor switching stage 20, using a temperature model. For instance, based on the current flowing between input terminal 11 and output terminal 12, power control apparatus 1 could calculate an estimated temperature of semiconductor switching stage 20.

Additionally, control unit 410 may receive other relevant data or information, potentially through interface 420, which could also receive signals from a temperature sensor. Alternatively, a separate interface 420 could be used to collect additional data. This data could specify the degree of temperature dependency required for the compensation network, enabling an adjustment of the temperature-dependent function accordingly.

This information could be provided digitally, possibly via a communication protocol, or manually configured through an input device 421. Such an input device could include switches, jumpers, or similar controls, allowing users to easily configure these to achieve the desired setup.

In summary, the present invention relates to a power control apparatus for controlling electrical current between an input terminal and an output terminal. The current in the path between these two terminals can be monitored, with the monitoring signal corresponding to the current in the path being adjustable based on the temperature within the control apparatus.

## Claims

1. A power control apparatus (1) for controlling electrical power supplied to a connected load (3), said power control apparatus (1) comprising:
an input terminal (11) configured to be connected to an electrical power source (2);
an output terminal (12) configured to be connected to the load (3);
a semiconductor switching stage (20) through which the connected load (3) receives a load current, wherein the semiconductor switching stage (20) comprises two power switches arranged in series between the input terminal (11) and the output terminal (12), and wherein the two power switches have opposite orientations;
an evaluation circuit (40) adapted to evaluate a current between the input terminal (11) and the output terminal (12), and to provide an output signal based on the evaluated current; and
a thermal compensation unit (40), adapted to adjust the output signal based on a temperature in a power path between the input terminal (11) and the output terminal (12).

2. The power control apparatus (1) according to claim 1, comprising a conductive or inductive element (311, 312, 321, 322) in the current path between the input terminal (11) and the output terminal (12), wherein the elevation circuit (40) is adapted to identify a predetermined condition of the current between the input terminal (11) and the output terminal (12) based on a voltage drop over the conductive or inductive element (311, 312, 321, 322).

3. The power control apparatus (1) according to claim 1 or 2, wherein the temperature in the power path between the input terminal (11) and the output terminal (12) comprises a temperature of the semiconductor switching stage (20).

4. The power control apparatus (1) according to any of claims 1 to 3, wherein the thermal compensation unit (43) comprises a temperature-dependent resistor (T).

5. The power control apparatus (1) according to any of claims 1 to 4, wherein the thermal compensation unit (43) comprises a compensation network with multiple resistors (Rnl, Rn2) and/or capacitors (Cn1, Cn2), the compensation network being adapted to selectively connect the individual resistors (Rn1, Rn2) and/or capacitors (Cn1, Cn2) to an output port (41) providing the output signal.

6. The power control apparatus (1) according to claim 5, comprising a control unit (410) configured to control the compensation network based on the temperature in the power path between the input terminal (11) and the output terminal (12) .

7. The power control apparatus (1) according to claim 5 or 6, comprising at least one temperature sensor configured to provide a sensor signal that corresponds to the temperature in the power path between the input terminal (11) and the output terminal (12).

8. The power control apparatus (1) according to any of claims 5 to 7, wherein the thermal compensation unit (43) is configured to adjust a degree of thermal compensation for the output signal.

9. The power control apparatus (1) according to claim 8, wherein the control unit (410) comprises a communication interface (420) configured to establish a communication to a remote device.

10. The power control apparatus (1) according to claim 8, wherein the control unit (410) comprises an input unit (421) configured to receive at least one input parameter from a user for adjusting the degree of thermal compensation for the output signal.

11. The power control apparatus (1) according to any of claims 6 to 10, comprising a memory configured to provide a relationship between the temperature in the power path between the input terminal (11) and the output terminal (12) and the degree of thermal compensation for the output signal.
